# FASCICULE DE BREVET EUROPEEN

(11) **EP 2 656 457 B1**
(45) Date de publication et mention de la délivrance du brevet: **12.12.2018**
(21) Numéro de dépôt: 11802079.1
(22) Date de dépôt: 20.12.2011
(51) Int. Cl.: H02B 1/06, G01R 11/24, H05K 5/02

(54) **AGENCEMENT DE BOÎTIER COMPRENANT UN CAPOT SERTI POUR RENDRE VISIBLE UNE TENTATIVE D'OUVERTURE FRAUDULEUSE DE CE CAPOT**
GEHÄUSEANORDNUNG MIT EINEM GEKRIMPTEN DECKEL, UM EINEN UNBERECHTIGTEN VERSUCH DER DECKELÖFFNUNG SICHTBAR ZU MACHEN
CASING ARRANGEMENT COMPRISING A CRIMPED CAP FOR MAKING VISIBLE AN ILLICIT ATTEMPT AT OPENING THIS CAP

(30) Priorité: 23.12.2010 FR 1061215
(43) Date de publication de la demande: 30.10.2013
(73) Titulaire: Sagemcom Energy & Telecom SAS, 92500 Rueil-Malmaison (FR)
(72) Inventeur: ROLLAND, Patrick, F-92500 Rueil-Malmaison (FR)
(74) Mandataire: Beaudouin-Lafon, Emmanuel
(86) Numéro de dépôt international: PCT/EP2011/073343
(87) Numéro de publication internationale: WO 2012/084902

(56) Documents cités:
- CN-Y- 201 203 640
- DE-A1-102007 002 006
- GB-A- 2 196 056
- GB-A- 2 431 244

## Description

L'invention concerne un agencement de sertissage du capot d'un appareil de type compteur électrique, conçu pour rendre visible une tentative d'ouverture de ce capot.

### ARRIERE PLAN DE L'INVENTION

Un compteur électrique individuel comporte typiquement un châssis destiné à être fixé à un mur et portant un ensemble de composants, ainsi qu'un capot se montant sur le châssis, par exemple par encliquetage, pour masquer et protéger l'ensemble des composants que renferme l'appareil.

Afin de réduire le risque de fraude par un utilisateur, le capot est serti sur le châssis après fabrication et avant installation du compteur, attendu qu'un utilisateur souhaitant intervenir frauduleusement sur le compteur pour réduire le décompte de consommation électrique, doit nécessairement ouvrir le capot pour agir sur les composants internes de l'appareil.

L'utilisateur souhaitant frauder est ainsi conduit à briser le sertissage pour retirer le capot, de sorte que sa manipulation est finalement visible sur le compteur, en particulier lors d'une inspection visuelle ultérieure par un agent du réseau de distribution électrique qui identifie alors que le sertissage a été brisé.

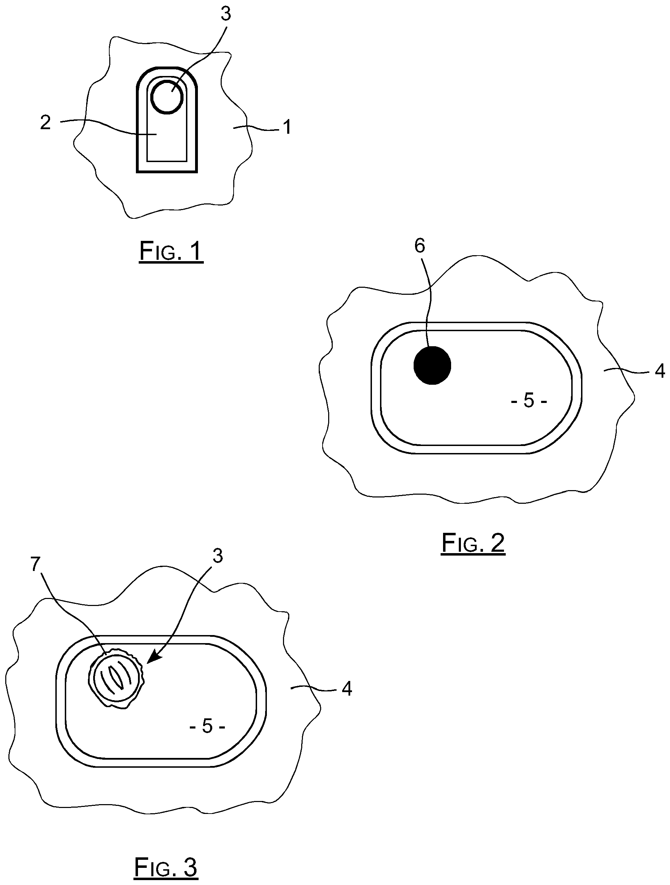

A cet effet, le châssis d'un tel compteur, représenté partiellement en figure 1 en y étant repéré par 1, comporte typiquement un pied 2 dépassant vers le capot, et se terminant par un plot 3. Complémentairement, le capot, représenté partiellement dans la figure 2 en y étant repéré par 4, comporte un trou correspondant 6 destiné à recevoir le plot 3.

Pour réaliser ce compteur, le capot est emboîté sur le châssis, pour refermer l'ensemble, de sorte que le plot 3 dépassant du châssis 1 traverse le trou 6. Pour sertir le capot 1, un poinçon chaud est appliqué, dans l'usine de fabrication, sur l'extrémité dépassante du plot 3, ce qui a pour effet de bouteroller cette extrémité, en formant un bourrelet périphérique 7 ayant un diamètre supérieur à celui du trou 6 tout en étant rigidement solidaire du plot 3, le capot avec le pion serti étant représentés en figure 3.

Complémentairement, le poinçon porte une marque spécifique qui laisse son empreinte sur l'extrémité de pion sertie, attestant du fait que le sertissage a été assuré par l'entreprise ayant la charge du compteur, cette marque spécifique se présentant sous la forme de trois traits courbes dans l'exemple des figures.

De plus, le trou 6 est situé, dans ce cas de figure, dans une région 5 du capot qui est légèrement en retrait par rapport au reste de la face avant du capot 4. Ainsi, l'utilisateur frauduleux ne peut pas, de manière simple, passer une lame coupante derrière le bouterollage du plot afin de le retirer pour ouvrir le capot en vue de recoller l'extrémité sertie après remontage afin de rendre sa manipulation invisible.

Ainsi, avec cette solution connue, lorsque le capot 4 est retiré en force, à l'encontre du sertissage du plot 3, l'extrémité sertie doit nécessairement être brisée pour permettre le retrait complet du capot.

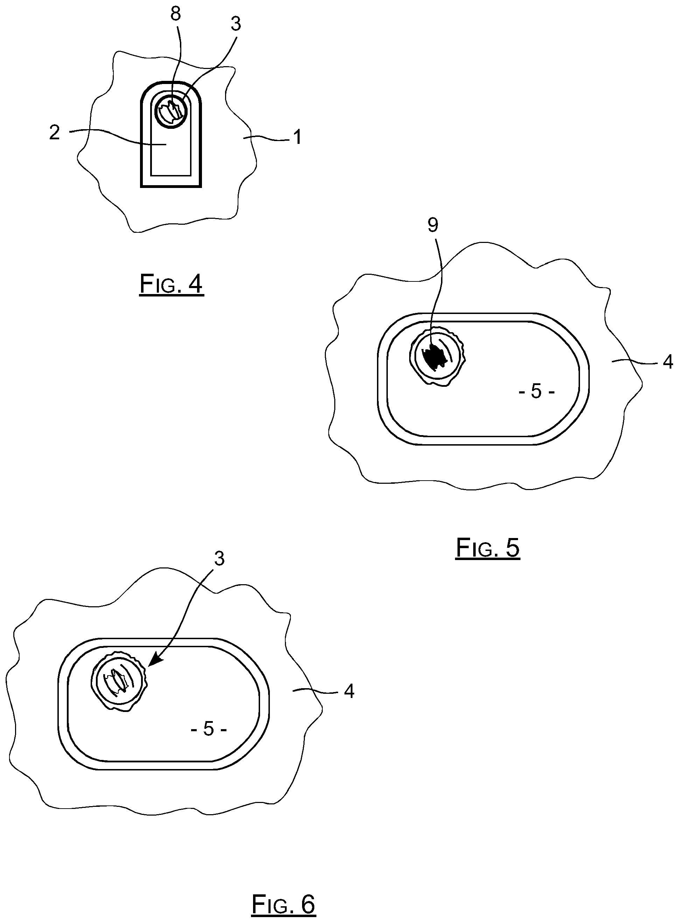

Il est néanmoins courant que l'extrémité sertie se brise, sensiblement le long des marques du poinçon, laissant uniquement un fragment central 8 attaché au corps du plot 3, comme illustré en figure 4, ainsi qu'un trou correspondant 9 au niveau du reste de l'extrémité sertie qui est généralement solidarisée au capot, comme représenté en figure 5.

Dans ces conditions, l'utilisateur peut, après être intervenu sur les composants du compteur, replacer le capot sur le châssis : le fragment central s'emboîte assez facilement dans le trou correspondant 9, de sorte que l'endommagement du sertissage est en fin de compte très peu visible.

Comme illustré schématiquement en figure 6, une fois que l'ensemble a été remonté, l'endommagement du sertissage se résume à une ligne de fracture, qui est d'une part relativement fine, et qui est de plus perdue dans la marque du poinçon.

Dans d'autres situations, le plot 3 se brise spontanément à sa base durant le retrait du capot, de sorte que le sertissage est complètement intact et peut ainsi être recollé ultérieurement, rendant alors la manipulation de l'utilisateur frauduleux complètement invisible.

### OBJET DE L'INVENTION

Le but de l'invention est de proposer une solution pour remédier aux inconvénients ci-dessus.

### RESUME DE L'INVENTION

A cet effet, l'invention a pour objet un boîtier tel que défini dans la revendication 1.

L'invention concerne également un boîtier tel que défini ci-dessus, dans lequel la zone d'affaiblissement mécanique comporte au moins une rainure à la face arrière du capot.

L'invention concerne également un boîtier tel que défini ci-dessus, dans lequel la zone d'affaiblissement mécanique comporte une série de rainures orientées radialement par rapport au trou.

L'invention concerne également un boîtier tel que défini ci-dessus, dans lequel le trou de passage du plot présente un contour crénelé.

L'invention concerne également un boîtier tel que défini ci-dessus, dans lequel la zone d'affaiblissement comporte plusieurs rainures radiales de différentes longueurs.

L'invention concerne également un boîtier tel que défini ci-dessus, comprenant une rainure en forme de spirale entourant le trou de passage du plot.

L'invention concerne également un boîtier tel que défini ci-dessus, dans lequel la rainure en forme de spirale présente une profondeur qui varie le long de cette spirale.

L'invention concerne également un boîtier tel que défini ci-dessus, dans lequel le capot présente à sa face avant des inscriptions laser au voisinage du trou de passage du plot.

L'invention concerne également un boîtier tel que défini ci-dessus, dans lequel les inscriptions laser comprennent des marquages rectilignes et/ou des marquages circulaires.

### BREVE DESCRIPTION DES FIGURES

- La figure 1 déjà décrite est une vue de face d'une portion de châssis d'un appareil connu ;
- la figure 2 déjà décrite est une vue de face d'une portion de capot d'un appareil connu ;
- la figure 3 déjà décrite est une vue de face d'un capot serti sur un châssis dans un appareil connu ;
- la figure 4 déjà décrite est une vue de face montrant un plot d'un appareil connu après retrait en force du capot à l'encontre du sertissage ;
- la figure 5 déjà décrite est une vue de face montrant un capot d'appareil connu après retrait en force du capot à l'encontre du sertissage ;
- la figure 6 déjà décrite est une vue de face montrant le capot d'un appareil connu remis en place après son retrait en force à l'encontre du sertissage ;
- la figure 7 est une vue arrière du capot de l'appareil selon l'invention ;
- la figure 8 est une vue de détail de l'arrière du capot de l'appareil selon l'invention montrant des affaiblissements réalisés autour du trou de passage du plot ;
- la figure 9 est une vue de l'arrière du capot de l'appareil selon un second mode de réalisation de l'invention ;
- la figure 10 est une vue de face du capot de l'appareil selon l'invention une fois qu'il a été remis en place après retrait en force à l'encontre du sertissage.

### DESCRIPTION DETAILLEE DE L'INVENTION

L'idée à la base de l'invention est de faire en sorte qu'un retrait en force du capot puisse provoquer éventuellement d'une part la rupture du sertissage, mais surtout une déformation permanente du capot au voisinage du sertissage, cette déformation permanente étant alors nécessairement plus visible que la rupture du sertissage en soi, une fois que le capot a été remonté.

A cet effet, le capot est dimensionné de telle manière que son retrait en force à l'encontre du sertissage provoque nécessairement une déformation permanente, avec ou sans rupture, de la paroi du capot, au voisinage du trou de passage du plot serti. Cette propriété est obtenue en affaiblissant le capot localement au voisinage du trou recevant le plot de fixation.

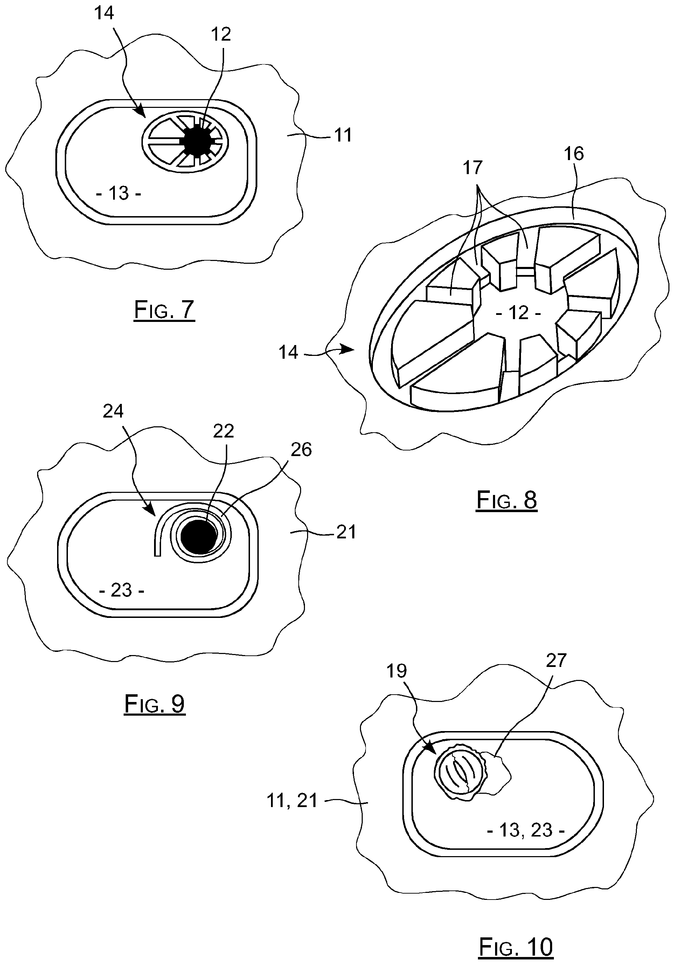

Le capot des figures 7 à 10 est destiné à être fixé à un châssis du même type que celui représenté aux figures 1 à 6, par exemple par encliquetage, c'est-à-dire un châssis comportant un plot dépassant vers l'avant en étant destiné à traverser un trou du capot pour être serti.

Le capot selon l'invention 11, dont la figure 7 montre une partie de la paroi avant en vue arrière, comporte ainsi un trou 12 de passage d'un plot de sertissage non représenté, ce trou 12 étant situé dans une région 13 sensiblement en retrait par rapport à la face avant du capot, tout comme dans le cas du capot connu des figures 2, 3, 5 et 6.

Selon l'invention, le capot comporte une zone d'affaiblissement 14 entourant le trou 12, cette zone d'affaiblissement est constituée par la formation, à la face avant de la paroi avant du capot, d'un ensemble de rainures entourant le trou 12.

Cet ensemble de rainures comporte d'une part une rainure elliptique 16 entourant le trou 12 en étant légèrement décentrée par rapport à celui-ci, et un ensemble de huit rainures radiales, repérées par 17, qui partent chacune du bord interne du trou 12 pour rejoindre la rainure elliptique 16, ces rainures radiales étant régulièrement espacées les unes des autres autour du trou central 12.

Chaque rainure 16, 17 présente une profondeur valant ici sensiblement la moitié de l'épaisseur de la paroi avant du capot, de manière à faciliter la déformation de ce capot, voire localement sa rupture ou sa déchirure, lorsqu'il est retiré à l'encontre du sertissage. Comme on le comprend, la valeur de cette profondeur est choisie en fonction des qualités mécaniques du matériau utilisé, de manière à provoquer l'effet souhaité, à savoir une déformation permanente avec avantageusement rupture localisée, ou déchirure, en cas de retrait du capot en force à l'encontre du sertissage.

Dans l'exemple des figures 7 et 8, grâce à la disposition en ellipse qui est décentrée par rapport au trou 12, les différentes nervures radiales 17 présentent des longueurs différentes, ce qui contribue à offrir toute une gamme de flexibilités de la paroi au voisinage du trou 12, dans le but de provoquer tout type de déformation permanente dans cette région, allant de la simple déformation plastique jusqu'à la rupture.

Complémentairement, comme visible dans la figure 7 et montré plus clairement sur la figure 8, le bord intérieur du trou 12 a une forme qui est crénelée de manière à favoriser la rupture du matériau lorsque le capot est retiré à l'encontre du sertissage.

Concrètement, les différents crénelages délimitant le trou 12 constituent autant d'entailles, ou amorces de rupture, qui favorisent le déchirement du matériau constituant la paroi avant. Au contraire, un trou ayant son contour ou bord constitué par une surface régulière cylindrique, offre une résistance importante au déchirement, du fait de l'effet de peau dû à la forme très régulière de son contour interne.

Dans un autre mode de réalisation de l'invention qui est mis en oeuvre sur un capot repéré par 21 dans la figure 9, le trou central 22 destiné à recevoir un plot de sertissage est là aussi situé dans une région en retrait 23 de la paroi avant du capot, mais l'affaiblissement 24 de la paroi au voisinage du trou 22 est assuré par une unique rainure 26 en forme de spirale qui entoure ce trou.

Cette unique rainure en forme de spirale peut avoir une profondeur constante valant par exemple la moitié de l'épaisseur de la paroi frontale du capot. Mais cette profondeur peut avantageusement être prévue évolutive le long de la rainure 26, de façon à offrir tout une gamme de qualités mécaniques favorisant par là même l'apparition de déformations plastiques, de ruptures localisées et/ou de déchirements de la paroi lorsque le capot est retiré en force à l'encontre du sertissage.

Comme visible dans la figure 10, la face avant du capot a avantageusement une forme régulière, plane et lisse dans la région d'affaiblissement qui entoure le sertissage, de manière à rendre la détérioration de cette portion de paroi parfaitement visible à l'oeil nu.

Dans ces conditions, le retrait du capot en force à l'encontre du sertissage repéré par 19 dans la figure 10, peut provoquer d'une part la rupture du sertissage, qui est relativement peu visible, mais provoque également une détérioration de la paroi avant du capot, représentée par une ligne courbe 27 sur la figure 10.

La détérioration représentée par la courbe 27 correspond à une déformation plastique avec ou sans cassure et déchirement de la paroi avant du capot, et cette déformation est très visible à la face avant du capot qui est lisse et régulière. A contrario, la rupture du sertissage donne lieu à une ligne de brisure située au niveau des marques du poinçon utilisé pour réaliser le sertissage, de sorte qu'elle est très peu visible une fois que l'ensemble a été remis en place, comme c'est le cas dans la figure 10.

Dans ces conditions, du fait de la déformation plastique du capot due à l'arrachement de celui-ci à l'encontre du sertissage, le sertissage endommagé ne peut généralement plus être remboîté dans la paroi avant du capot. Qui plus est, le capot étant réalisé dans un matériau plastique, la déformation plastique ou pliure de la paroi dans la zone de déformation blanchit cette paroi le long des pliures, ce qui rend la déformation encore plus détectable à l'oeil nu.

Complémentairement, on peut prévoir un marquage à la face avant du capot, dans le voisinage du trou de passage du plot, de manière à rendre le blanchiment de la portion déformée encore plus évident à l'oeil nu.

Ce marquage peut par exemple se présenter sous forme d'inscriptions gris foncé, réalisées par un procédé laser, et être basé sur des lignes rectilignes ou circulaires, de manière à rendre en outre la déformation de ces lignes ou cercles encore plus visibles du fait de la déformation permanente du capot.

Ce marquage peut être réalisé dans le voisinage du plot de sertissage, mais également sur le sertissage en soi, en remplacement d'un marquage formant des traits en creux du type rainure ou analogue résultant de l'application d'une empreinte chaude. Ce marquage laser permet de rendre apparentes les déformations ou cassures du matériau, par opposition à un marquage par empreinte formant des traits de type rainures qui constituent en soi des amorçes de ruptures masquant les ruptures qu'ils provoquent.

## Revendications

1. Boîtier d'appareil, comprenant un châssis et un capot (11 ; 21), ainsi que des moyens de fixation du capot (11 ; 21) au châssis, le châssis comprenant un plot s'engageant dans un trou (12 ; 22) correspondant du capot (11 ; 21), ce plot présentant une extrémité destinée à être sertie, **caractérisé en ce que** le capot (11 ; 21) est dimensionné pour que son retrait à l'encontre du sertissage produise nécessairement une déformation permanente du capot (11 ; 21) dans le voisinage (14 ; 24) du trou (12 ; 22), cette déformation permanente étant visible à l'oeil nu sur la face externe du capot (11 ; 21), le capot comportant, au voisinage du trou (12 ; 22), une zone (14 ; 24) d'affaiblissement mécanique.

2. Boîtier selon la revendication 1, dans lequel la zone d'affaiblissement mécanique (14 ; 24) comporte au moins une rainure (16, 17 ; 26) à la face arrière du capot (11 ; 21).

3. Boîtier selon la revendication 2, dans lequel la zone d'affaiblissement mécanique (14) comporte une série de rainures (17) orientées radialement par rapport au trou (12).

4. Boîtier selon la revendication 3, dans lequel le trou (12) de passage du plot présente un contour crénelé.

5. Boîtier selon la revendication 3 ou 4, dans lequel la zone d'affaiblissement (14) comporte plusieurs rainures radiales (17) de différentes longueurs.

6. Boîtier selon la revendication 2, comprenant une rainure (26) en forme de spirale entourant le trou (22) de passage du plot.

7. Boîtier selon la revendication 6, dans lequel la rainure (26) en forme de spirale présente une profondeur qui varie le long de cette spirale (26).

8. Boîtier selon l'une des revendications précédentes, dans lequel le capot (11 ; 21) présente en face avant des inscriptions laser au voisinage du trou (12 ; 22) de passage du plot.

9. Boîtier selon la revendication 8, dans lequel les inscriptions laser comprennent des marquages rectilignes et/ou des marquages circulaires.

## Patentansprüche

1. Gehäuse für ein Gerät, umfassend einen Rahmen und eine Abdeckung (11; 21) sowie Mittel zur Befestigung der Abdeckung (11; 21) am Rahmen, wobei der Rahmen einen Stift umfasst, der in ein entsprechendes Loch (12; 22) der Abdeckung (11; 21) eingreift, wobei dieser Stift ein Ende aufweist, das dazu bestimmt ist, gecrimpt zu werden, **dadurch gekennzeichnet, dass** die Abdeckung (11; 21) so bemessen ist, dass ihr Entfernen entgegen der Crimpverbindung zwangsläufig eine dauerhafte Verformung der Abdeckung (11; 21) in der Nähe (14; 24) des Loches (12; 22) erzeugt, wobei diese dauerhafte Verformung mit bloßem Auge auf der Außenfläche der Abdeckung (11; 21) sichtbar ist, wobei die Abdeckung nahe dem Loch (12; 22) einen Bereich (14; 24) mechanischer Schwächung umfasst.

2. Gehäuse nach Anspruch 1, bei dem die Zone (14; 24) mechanischer Schwächung mindestens eine Nut (16, 17; 26) auf der Rückseite der Abdeckung (11; 21) umfasst.

3. Gehäuse nach Anspruch 2, bei dem die Zone (14) mechanischer Schwächung eine Reihe von Nuten (17) umfasst, die in Bezug auf das Loch (12) radial ausrichtet sind.

4. Gehäuse nach Anspruch 3, bei dem das Durchgangsloch (12) zum Durchtritt des Stiftes eine gezackte Kontur aufweist.

5. Gehäuse nach Anspruch 3 oder 4, bei dem die Schwächungszone (14) mehrere radiale Nuten (17) mit unterschiedlichen Längen aufweist.

6. Gehäuse nach Anspruch 2, umfassend eine Nut (26) in Form einer Spirale, die das Durchgangsloch (22) zum Durchtritt des Stiftes umgibt.

7. Gehäuse nach Anspruch 6, bei dem die Nut (26) in Form einer Spirale eine Tiefe aufweist, die entlang dieser Spirale (26) variiert.

8. Gehäuse nach einem der vorhergehenden Ansprüche, bei dem die Abdeckung (11; 21) eine Vorderseite mit Laserbeschriftungen nahe des Durchgangsloches (12; 22) zum Durchtritt des Stiftes aufweist.

9. Gehäuse nach Anspruch 8, bei dem die Laserbeschriftungen geradlinige Markierungen und/oder kreisförmige Markierungen umfassen.

## Claims

1. Appliance casing comprising a base and a cap (11; 21) together with means for fastening the cap (11; 21) to the base, the base having a stud that engages in a corresponding hole (12; 22) of the cap (11; 21), the stud presenting an end that is to be crimped, the casing being **characterized in that** the cap (11; 21) is dimensioned so that removal of the cap against the crimping necessarily leads to permanent deformation of the cap (11; 21) in the vicinity (14; 24) of the hole (12; 22), this permanent deformation being visible to the naked eye on the outside face of the cap (11; 21), the cap including a zone (14; 24) of mechanical weakening in the vicinity of the hole (12; 22).

2. Casing according to claim 1, wherein the zone (14; 24) of mechanical weakening includes at last one groove (16, 17; 26) in the rear face of the cap (11; 21).

3. Casing according to claim 2, wherein the zone (14) of mechanical weakening comprises a series of grooves (17) that are radially oriented relative to the hole (12).

4. Casing according to claim 3, wherein the hole (12) for passing the stud presents a crenellated outline.

5. Casing according to claim 3 or claim 4, wherein the zone (14) of weakening comprises a plurality of radial grooves (17) of different lengths.

6. Casing according to claim 2, including a groove (26) of spiral shape surrounding the stud-passing hole (22).

7. Casing according to claim 6, wherein the spiral-shaped groove (26) presents a depth that varies along the spiral (26) .

8. Casing according to any preceding claim, wherein the cap (11; 21) presents laser inscriptions on its front face in the vicinity of the stud-passing hole (12; 22).

9. Casing according to claim 8, wherein the laser inscriptions comprise rectilinear markings and/or circular markings.
